# FASCICULE DE BREVET EUROPEEN

(11) **EP 0 689 253 B1**
(45) Date de publication et mention de la délivrance du brevet: **06.05.1998**
(21) Numéro de dépôt: 95401446.0
(22) Date de dépôt: 20.06.1995
(51) Int. Cl.: H01L 33/00, H01S 3/25

(54) **Procédé de réalisation d'une matrice de composants à puits quantiques de structure verticale commandable électriquement**
Verfahren zur Herstellung einer Matrix aus elektrisch steuerbaren Quantumwell-Komponenten mit vertikaler Struktur
Process for producing an array of electrically driven quantum well components having a vertical structure

(30) Priorité: 22.06.1994 FR 9407640
(43) Date de publication de la demande: 27.12.1995
(73) Titulaire: FRANCE TELECOM, 75015 Paris (FR)
(72) Inventeur: Nissim, Yves, F-75020 Paris (FR); Bensoussan, Marcel, F-92100 Boulogne (FR)
(74) Mandataire: Warcoin, Jacques

(56) Documents cités:
- US-A- 5 031 187
- APPLIED PHYSICS LETTERS., vol. 49, no. 9, 1 Septembre 1986 NEW YORK US, pages 510-512, D.G. DEPPE ET AL. 'Stripe-geometry quantum well heterostructure AlxGa1-xAs-GaAs lasers defined by defect diffusion'
- APPLIED PHYSICS LETTERS., vol. 60, no. 5, 3 Février 1992 NEW YORK US, pages 607-609, B.G. SFEZ ET AL. 'Operation of nonlinear GaAs/AlGaAs multiple quantum well microresonators fabricated using alloy-mixing techniques'
- PROCEEDINGS OF THE ROYAL MICROSCOPICAL SOCIETY CONFERENCE, PROCEEDINGS OF MICROSCOPY OF SEMICONDUCTING MATERIALS, no. 134, 5 Avril 1993 OXFORD, UK, pages 459-462, A. PEPIN ET AL. 'Intermixing mechanisms in single GaAs/GaAlAs quantum well samples under SiO2 capping'
- PATENT ABSTRACTS OF JAPAN vol. 16 no. 340 (E-1238) ,23 Juillet 1992 & JP-A-04 103186 (MITSUBISHI ELECTRIC CORP) 6 Avril 1992,
- PATENT ABSTRACTS OF JAPAN vol. 16 no. 204 (E-1202) ,15 Mai 1992 & JP-A-04 033380 (OMRON CORP) 4 Février 1992,

## Description

L'invention concerne un procédé de réalisation d'une matrice de composants à puits quantiques de structure verticale commandable électriquement à partir d'un substrat sur lequel a été épitaxié un miroir de Bragg inférieur composé d'une ou plusieurs alternances de couches minces semiconductrices surmonté d'une couche active formée d'hétérostructures à puits quantiques à base de composés III/V.

L'exploitation du parallélisme pour augmenter le débit dans le traitement du signal optique, passe en grande partie par la mise en oeuvre de dispositifs formés de composants à structures verticales à puits quantiques sous forme de matrices , tels que les lasers à émission par la surface, les modulateurs, les bistables optiques. La fabrication de ce type de matrices et leur intégration monolithique en micro-optoélectronique nécessite de pouvoir faire varier dans un même plan les propriétés du matériau afin de réaliser localement soit du confinement optique, soit du confinement électronique, soit de l'absorption optique, soit une combinaison des trois. Il faut de plus introduire dans ces structures verticales des contacts métalliques permettant d'exciter la zone active du composant.

Les possibilités offertes par les techniques modernes de croissance de couches minces épitaxiées ont ouvert un large champ d'applications à l'ingénierie des structures à puits quantiques pour les dispositifs à semiconducteurs en micro-optoélectronique. La maitrise de ces techniques de croissance est aujourd'hui telle qu'il est possible de contrôler une croissance de couches minces à la monocouche atomique près. On obtient ainsi des puits quantiques d'une grande qualité avec des interfaces très abruptes où grâce simplement à un paramètre géométrique (épaisseur du puits et/ou insertion dans le puits pendant la croissance d'un plan atomique différent de la matrice), il est possible de réaliser dans une même famille de matériaux (même bâti de croissance, même cellules, même conditions de croissance), la propriété nécessaire (bande interdite, force d'oscillateur ....) pour l'application recherchée. Cependant, cette ingénierie ne donne accès qu'aux propriétés 2D (à deux dimensions), c'est-à-dire aux propriétés de quantification le long de l'axe de croissance.

La mise en matrices des composants micro-opto électroniques à partir de ces hétérostructures consiste à façonner latéralement la structure. Ceci est obtenu habituellement par une succession d'étapes technologiques qui dépendent du composant à réaliser : masquage, gravure, reprise d'épitaxie, passivation... . Ces technologies s'appliquent aux composants à structures verticales, pour lesquels il s'agit de mettre en contact intime des matériaux assez semblables mais ayant néanmoins des propriétés électriques et optiques différenciées afin de réaliser un confinement optique et électrique vertical.

Le composant individuel à structure verticale est formé d'une cavité verticale (normale au plan de la surface de l'échantillon) constitué d'une couche active comprise entre deux miroirs de Bragg (inférieur et supérieur). La couche active contient des puits quantiques réalisés par une alternance de matériaux composés semiconducteurs. Les miroirs sont de très haute réflectivité. Ces miroirs sont constitués d'alternance de couches semiconductrices dont l'épaisseur est déterminée par la longueur d'onde de travail du composant suivant les conditions de Bragg (miroir de Bragg). L'injection de porteurs dans la zone active de ce composant se fait électriquement. Les structures sont par exemple de type PIN : P (miroir supérieur), I (cavité), N (miroir inférieur). Pour obtenir une commande électrique sur ce genre de structure, il faut contacter séparément le miroir inférieur et le miroir supérieur. Le contact sur le miroir inférieur se fait à travers le substrat (on met à la masse la face arrière du substrat). Le contact est alors assuré si le substrat est de même type que le miroir inférieur. Dans le cas traité ici, le substrat sera de type n. Le miroir supérieur sera métallisé individuellement pour chaque pixel. Le côté isolant de la cavité permet l'isolation entre les deux prises de contact.

Le dopage de chacune des régions est donc important et déterminé lors de la croissance de la structure. Ces composants sont réalisés sous forme matricielle et peuvent être soit des lasers à émission par la surface, soit des amplificateurs, soit des modulateurs soit des portes optiques bistables ou toute juxtaposition ou superposition de dispositifs de ce type, tous pompés électriquement.

Il existe actuellement deux techniques pour fabriquer des matrices de structures verticales (pixel) commandables électriquement :
- La matrice de pixels peut être réalisée par lithographie et attaque ionique réactive. Dans ce cas, la mise en oeuvre est longue (attaque ionique sur une profondeur de plusieurs microns d'un matériau composé de plusieurs couches de nature différente), la structure n'est plus plane et enfin les flancs de pixels nécessitent une passivation que l'on ne maîtrise pas encore aujourd'hui.
- La matrice de pixels peut être obtenue par désordre d'alliage induit par implantation ionique, selon B.G. Sfez et al., Appl. Phys. Lett. 60, 607, 1992, la fabrication est alors coûteuse (implanteur). De plus, le repérage des pixels nécessite l'utilisation d'une technique complémentaire (cartographie de luminescence par exemple), car le masque d'implantation définissant la position des pixels doit être enlevé pour la suite des étapes technologiques.

Enfin, la technique d'implantation ionique introduit dans les régions implantées des défauts structuraux et des impuretés qui ne sont pas souhaitables pour conserver l'intégrité des propriétés optiques des structures.

Les techniques de fabrication de ces matrices sont donc actuellement très complexes et ceci pèse d'un poids très lourd dans le coût du dispositif final. Il est important pour les développements industriels de ces matrices d'inventer des procédés technologiques fiables et reproductibles à grande échelle.

L'objet de ce brevet est de proposer un procédé simple de mise en oeuvre, versatile, permettant une intégration monolithique sous forme matricielle de composants à structure verticale et cela de façon autoalignée conduisant à une réduction du nombre d'étapes pour le processus de fabrication de structures verticales commandables électriquement.

Le procédé selon l'invention permet la réalisation d'une matrice de composants à puits quantiques de structure verticale commandable électriquement à partir d'un substrat dopé n (ou p) sur lequel est épitaxié un miroir de Bragg inférieur dopé n (ou p) composé d'une ou plusieurs alternances de couches minces semiconductrices surmonté (toujours par épitaxie) d'une couche active formée d'hétérostructures à puits quantiques non dopé caractérisé en ce que :
a) on encapsule la couche active à puits quantiques d'une couche diélectrique susceptible d'induire une interdiffusion d'alliage dans ladite couche active à puits quantiques,
b) on grave ladite couche diélectrique de façon à créer un masque d'autoalignement délimitant des évidements en regard des régions non recouvertes de la couche active (qui sont laissées intactes),
c) on traite thermiquement le substrat recouvert du masque d'autoalignement de façon à créer dans la couche active, par interdiffusion d'alliage, des régions à répartition verticale de composition modifiée par rapport à l'état de départ (régions interpixels) et des régions non modifiées (pixels) sous forme matricielle,
d) on dépose par reprise d'épitaxie sélectif dans les évidements du masque en regard des régions non modifiées (pixels) un miroir supérieur en matériau semiconducteur dopé de façon inverse au miroir inférieur, (dopé p dans l'exemple traité)
e) on métallise les bords des miroirs supérieurs de façon à laisser une ouverture au centre du miroir de chaque pixel pour les entrées-sorties du pixel.

De ce fait, le procédé selon l'invention utilise comme moyen une couche diélectrique provoquant l'interdiffusion de l'alliage mais qui sert également de masque d'autoalignement pour une reprise d'épitaxie locale sélective.

Cette couche diélectrique sert également d'isolant de métallisation pour le contact du miroir supérieur de chaque pixel et donc détermine l'emplacement de l'injection des porteurs.

La plaquette recouverte du masque d'autoalignement est réalisée par dépôt sur la couche active à puits quantiques d'un encapsulant diélectrique capable d'induire par interdiffusion une modification de composition perpendiculaire au substrat dans les hétérostructures à puits quantiques après recuit.

Ces techniques utilisant l'interdiffusion d'alliage ont déjà été décrites dans "Special issue on Quantum well mixing for optoelectronics of "Optical and Quantum Electronic", vol. 23 (1991) et par D.G. Deppe et al. "Stripe-Geometry Quantum Well Heterostructure AlGaAs/GaAs Lasers Defined by Defect Diffusion", Appl. Phys. Lett. 49, 510, 1986 et L.J. Guido et al."Effects of Dielectric Encapsulation and As Overpressure on Al-Ga Interdiffusion in AlGaAs-GaAs Quantum Well Heterostructures", J. of Appl. Phys., 61, 1372, 1987.

Par rapport à l'art antérieur, le procédé de réalisation d'une matrice commandable électriquement permet d'utiliser l'encapsulant diélectrique non seulement pour réaliser des motifs tridimensionnels grâce à la mise en oeuvre de l'interdiffusion localisée d'alliage, mais également comme masque d'autoalignement pour une épitaxie locale sélective du miroir supérieur et comme isolant de métallisation pour la prise de contact électrique sur le miroir supérieur.

Il est possible de faire varier le degré de mélange d'alliage introduit par l'interdiffusion induit par un tel encapsulant. Cette variation du degré de mélange est obtenue par le contrôle de la constitution de la couche et/ou par le contrôle de la tension mécanique induite par le film diélectrique sur la couche active. Ce dernier paramètre étant lui-même contrôlé par l'épaisseur ou la composition de l'encapsulant. Les matériaux capables de réaliser cette modification sont décrits dans le brevet FR-B-2 605 647.

Les conditions expérimentales de dépôt et l'épaisseur de cette couche sont prédéterminées pour tenir compte des conditions expérimentales de reprise d'épitaxie. En particulier, on devra veiller à ce que la stoechiométrie et la densité de la couche lui permettent une bonne tenue mécanique et chimique lors de la reprise d'épitaxie. Les conditions d'épitaxie sont en général l'exposition à des hydrures et des organométalliques sous forte température (≥ 700°C). L'épaisseur de l'isolant doit être calculée de façon à être supérieure ou égale à l'épaisseur du miroir semiconducteur, de façon à conserver l'isolation sur toute la hauteur du pixel. Les conditions de dépôt devront être telles que l'encapsulant soit le meilleur isolant électrique possible, c'est-à-dire que sa résistivité soit maximisée.

Par l'expression "couche négative", on entend une couche mince diélectrique déposée sur l'hétérostructure à puits quantiques et qui provoque une modification de composition de cette structure après recuit sur des profondeurs de plusieurs microns. Il s'agit en général de couche de type SiO, éventuellement SiO_{X}N_{y} avec y suffisamment petit pour que la couche à base de SiO_{X}N_{y} se comporte comme une couche négative.

Selon une variante avantageuse, l'encapsulant diélectrique est à base de SiO.

L'encapsulant est ensuite gravé par lithographie et RIE pour déterminer sous forme matricielle des évidements en regard de régions à ne pas modifier puis l'on traite thermiquement la plaquette ainsi recouverte du masque d'autoalignement afin de transférer le motif en profondeur dans la couche active grâce au phénomène d'interdiffusion d'alliage.

On traite thermiquement le substrat recouvert du masque d'autoalignement de façon à créer, par interdiffusion d'alliage, des régions à distribution de composition perpendiculaire au substrat, différentes suivant le dessin du masque, générant ainsi une matrice de pixels dont la couche active est non interdiffusée.

Le traitement thermique de la plaquette gravée consiste à la soumettre à une température de recuit donnée, pendant une durée déterminée, qui est calculée en fonction du décalage d'énergie de bande interdite que l'on souhaite obtenir entre zone interdiffusée et zone vierge (typiquement 850°C pendant un temps pouvant aller jusqu'à 4 heures).

Les deux types de recuit employés sont le recuit rapide par lampes halogènes et le recuit conventionnel dans un four classique. Le recuit rapide se caractérise par des temps de montée en température très courts, de l'ordre de 10 secondes pour atteindre 850°C (soit environ 100°C/sec) et des paliers en température de traitement thermique de 0 à quelques dizaines de secondes. Le recuit conventionnel présente des temps de montée de l'ordre de 5 minutes et des durées de paliers de 0 à plusieurs dizaines de minutes.

L'étape de recuit est généralement effectuée à 850°C environ.

La reprise d'épitaxie autoalignée sélective et localisée dans les ouvertures définies à l'étape précédente est effectuée de façon classique. On s'arrangera cependant lors de cette étape à éviter le facettage dans la direction (111) de façon à réaliser des tailles de pixels suffisamment petites ≦ 1 µm) et surtout de façon à respecter la taille de la zone non-interdiffusée définie dans le substrat.

Le dopage du miroir supérieur est déterminé pendant le dépôt. Le dopage est réalisé par exemple par l'introduction d'un élément (ou dopant) comme par exemple le carbone ou le beryllium. Il faut noter que la structure est autoalignée, il est possible de concevoir un dopage a posteriori (après épitaxie) par implantation du même élément.

L'invention s'applique de façon générale à toutes les hétérostructures à puits quantiques à base de matériaux III/V binaire, ternaire ou quaternaire à base de GaAs ou d'InP.

Il en est de même pour les couches minces à puits quantiques.

Parmi ces hétérostructures convenant dans le cadre de la présente invention, on peut citer les alternances de couches formées de la structure GaAs/Ga_{1-X}Al_{X}As avec O ≤ x ≤ 1. Mais le procédé peut s'étendre à d'autres types d'hétérostructures GaAs/Ga_{1-X}I n_{X}As avec O ≤ x ≤ 1.

On peut citer à titre indicatif les hétérostructures suivantes pour la zone active de la structure verticale : 130 périodes de GaAs/Ga_{0,7}Al_{0,3}As de 10 nm d'épaisseur pour chaque couche.

Dans le cas du miroir, 14 périodes de AlAs/A_{0,1}Ga_{0,9}As peuvent être utilisées.

On métallise les bords des miroirs supérieurs en utilisant la couche diélectrique comme isolant de contact par rapport au pixel voisin.

D'autres caractéristiques et avantages de ce procédé ressortiront encore de la description qui suit. Cette description est purement illustrative et non limitative. Elle doit être lue en regard des dessins annexés sur lesquels :
- Les figures 1 à 1c et 2 sont des vues en perspective et les figures 3a, 3b, 4a à 4c sont des coupes transversales.
- Les figures 1a à 1c illustrent de façon générale la mise en oeuvre du procédé conforme à l'invention jusqu'à la reprise d'épitaxie (étape b).
- La figure 2 illustre une première variante du procédé selon l'invention,
- Les figures 3a et 3b illustrent une seconde variante du procédé selon l'invention,
- Les figures 4a à 4c illustrent selon une troisième variante du procédé selon l'invention.

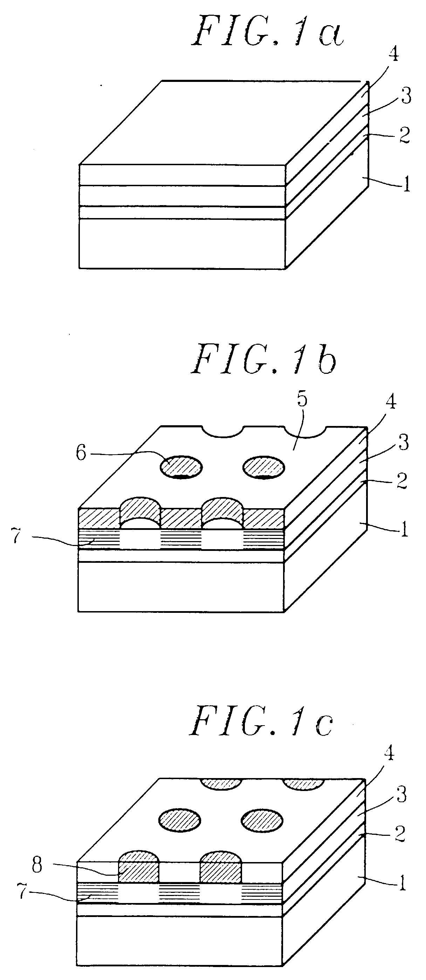

Sur les figures 1a à 1c, on a référencé par 1 le substrat dopé n d'une telle hétérostructure et par 2 le miroir inférieur dopé n et 3 la zone active intrinsèque constituée de puits quantiques.

Une fois la croissance du miroir inférieur et des couches à puits quantiques (2,3) sur le substrat 1 obtenue par des techniques classiques (figure la) on dépose sur les couches à puits quantiques 3 une couche 4 en un matériau diélectrique.

Conformément à l'invention, les conditions de dépôt et l'épaisseur de cette couche sont prédéterminées pour tenir compte des conditions expérimentales de reprise d'épitaxie (température, teneur aux hydrures et aux organométalliques). De plus, l'épaisseur de l'isolant doit être calculée de façon à conserver l'isolation sur toute la hauteur du pixel. En particulier, on s'assurera que les conditions de dépôt de l'encapsulant maximise l'isolation électrique interpixel apportée par cette couche.

Le dépôt est par exemple un dépôt chimique en phase vapeur assisté par thermie-rapide. Les techniques conventionnelles de photolithographie et de gravure permettent d'obtenir les géométries de dépôt souhaitées.

La couche de diélectrique est gravée par lithographie et RIE pour constituer un masque 5 délimitant des évidements 6.

Une fois le dépôt réalisé et le masque gravé, on traite thermiquement l'échantillon ainsi obtenu en le soumettant à une température de recuit donnée, pendant une durée déterminée, afin de créer le désordre d'alliage 7 dans les régions de la zone active 3, en regard du masque 5.

Les deux types de recuit employés sont le recuit rapide par lampes halogènes et le recuit conventionnel dans un four classique. Le recuit rapide se caractérise par des temps de montée en température très courts, de l'ordre de 10 secondes pour atteindre 850°C (soit environ 100°C/seconde) et des paliers en température de traitement thermique de 0 à quelques dizaines de secondes. Le recuit conventionnel présente des temps de montée de l'ordre de 5 minutes et des durées de paliers de 0 à plusieurs dizaines de minutes.

Le matériau diélectrique de la couche 4 est avantageusement SiO.

Les évidements 6 délimités par la géométrie du masque d'autoalignement sont comblés par une reprise d'épitaxie classique pour réaliser des pixels 8 qui constituent le miroir supérieur en matériaux semiconducteurs. Le dopage p de ce miroir supérieur est prévu pendant la croissance.

Si nécessaire, on effectue l'implantation ionique autoalignée dans ce miroir pour définir des régions de surdopage pour obtenir un contact ohmique.

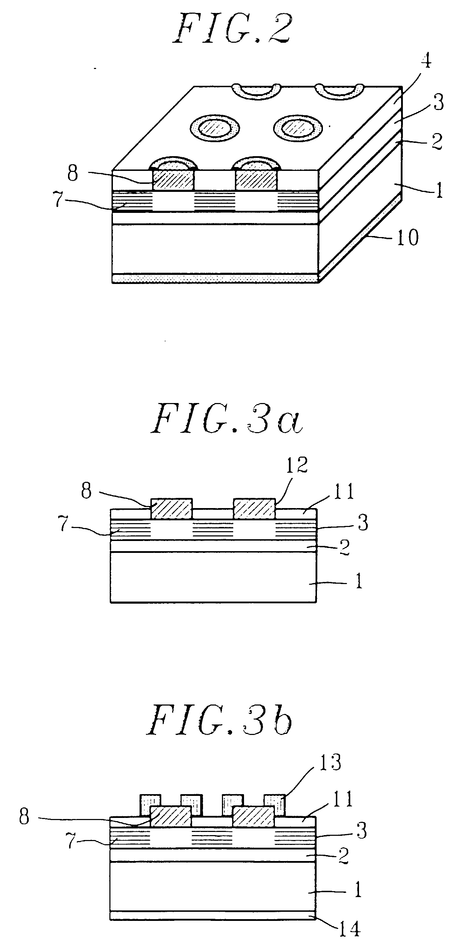

Une couronne de métallisation 9 est déposée tout autour de chaque pixel, l'isolant assurant l'isolation interpixel (figure 2) et une couche de contact arrière 10 est déposée sur la surface libre du substrat 1.

Selon la figure 3a, la couche diélectrique 11 a été enlevée sur une grande partie par attaque sélective chimique (solution de HF) du diélectrique pour ne laisser qu'une fine épaisseur isolante dégageant les flancs latéraux du miroir supérieur 12 des pixels. On procède ensuite à la métallisation 13 des bords supérieurs des pixels ainsi dégagés, le diélectrique assurant toujours l'isolation interpixel et au dépôt d'une couche de contact arrière 14 (figure 3b).

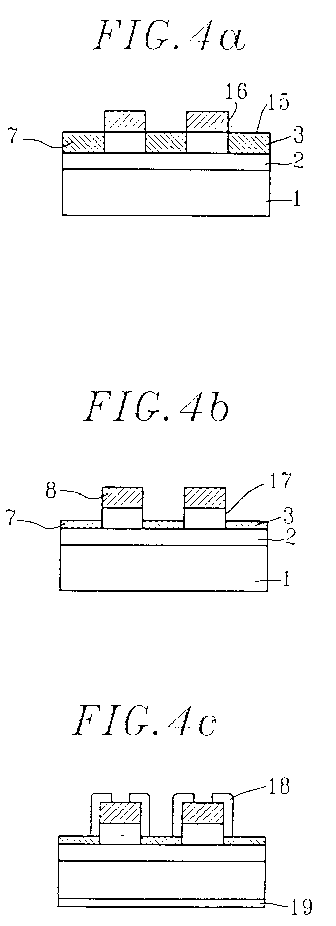

Selon la figure 4a, on a enlevé totalement le diélectrique par attaque chimique sélective découvrant ainsi la face supérieure 15 de chaque région 7 de la zone active où un désordre d'alliage a été induit ainsi que les flancs 16 des pixels.

On grave légèrement la région interpixel et le miroir supérieur de quelques 100 nm par RIE, en ayant pris soin, lors de la croissance, de laisser une zone tampon sur ce miroir d'une épaisseur équivalente (figure 4b). On procède ensuite à la métallisation 18 des contacts supérieurs (lithographie, dépôt de métal, lift off) permettant ainsi de contacter les flancs du miroir supérieur et de la zone active et au dépôt d'une couche de contact arrière 19 (figure 4c).

## Revendications

1. Procédé de réalisation d'une matrice de composants à puits quantiques de structure verticale commandable électriquement à partir d'un substrat (1) dopé n ou p sur lequel a été déposé par épitaxie un miroir inférieur (2) dopé n ou p composé d'une ou plusieurs alternances de couches minces semiconductrices surmonté d'une couche active (3) épitaxiée formée d'hétérostructures à puits quantiques, comprenant les étapes suivantes :
a) on encapsule la couche active à puits quantiques d'une couche diélectrique (4) susceptible d'induire une interdiffusion d'alliage dans ladite couche active à puits quantiques,
b) on grave ladite couche diélectrique (4) de façon à créer un masque d'autoalignement (5) limitant des évidements (6) en regard des régions non recouvertes de la couche active,
c) on traite thermiquement le substrat recouvert du masque d'autoalignement de façon à créer dans la couche active, par interdiffusion d'alliage, des régions (7) à répartition verticale de composition modifiée par rapport à l'état de départ correspondant aux régions interpixels et des régions non modifiées correspondant aux pixels sous forme matricielle,
d) on dépose par croissance épitaxiale dans les évidements du masque un miroir supérieur (8) en matériau semiconducteur dopé p (ou n) de façon inverse au miroir inférieur,
e) on métallise les bords des miroirs supérieurs en contact avec la couche diélectrique de façon à laisser une ouverture au centre du miroir de chaque pixel pour les entrées-sorties optiques du pixel.

2. Procédé selon la revendication 1, caractérisé en ce que la zone active à puits quantiques intrinsèque est du type GaAs/GaAlAs ou GaAs/GaInAs ou InP/InGaAs/InGaAsP.

3. Procédé selon la revendication 1, caractérisé en ce que le masque diélectrique est à base de SiO.

4. Procédé selon l'une des revendications là 3, caractérisé en ce que les miroirs supérieurs sont surdopés par implantation ionique pour assurer le contact ohmique.

5. Procédé selon la revendication 1, caractérisé en ce que l'épaisseur du masque diélectrique est au moins égale à l'épaisseur des miroirs supérieurs.

6. Procédé selon la revendication 1, caractérisé en ce que les contacts du miroir supérieur sont déposés en couronne autour du pixel et de manière à utiliser le masque diélectrique comme isolant interpixel.

7. Procédé selon la revendication 1, caractérisé en ce qu'avant métallisation, une partie substantielle de l'épaisseur du masque diélectrique est enlevée et l'on dépose la couche métallique sur les bords et les flancs découverts des miroirs supérieurs, la couche diélectrique restante assurant l'isolation électrique interpixel.

8. Procédé selon la revendication 1, caractérisé en ce qu'avant métallisation, le masque diélectrique et une partie des couches interdiffusées interpixel sont enlevées et l'on dépose la couche métallique sur les bords et les flancs des miroirs supérieurs, sur les flancs découverts des régions activées pixellisées, les régions interdiffusées, non pixellisées, restantes assurant l'isolation électrique interpixel.

## Patentansprüche

1. Verfahren zur Herstellung einer Matrix aus elektrisch steuerbaren Quantentopf-Elementen vertikaler Struktur ausgehend von einem n- oder p-dotierten Substrat (1), auf welchem mittels Epitaxie ein unterer n- oder p-dotierter Spiegel (2) aufgebracht wurde, der aus einer oder mehreren Wechelfolgen dünner Halbleiterschichten besteht und von einer epitaxisch hergestellten, aus Quantentopf-Heterostrukturen gebildeten aktiven Schicht (3) bedeckt ist, mit den folgenden Schritten:
a) die aktive Quantentopf-Schicht wird mit einer dielektrischen Schicht (4) eingekapselt, die dazu geeignet ist, in der aktiven Quantentopf-Schicht eine Legierungsinterdiffusion zu bewirken,
b) die dielektrische Schicht (4) wird derart strukturiert, daß eine Selbstausrichtungsmaske (5) entsteht, die Vertiefungen (6) gegenüber nicht von der aktiven Schicht bedeckten Regionen begrenzt,
c) das mit der Selbstausrichtungsmaske bedeckte Substrat wird derart thermisch behandelt, daß in der aktiven Schicht durch Legierungsdiffusion Regionen (7) vertikaler Einteilung, deren Zusammensetzung gegenüber dem Regionen zwischen Pixeln entsprechenden Ausgangszustand modifiziert ist, sowie gegenüber den Pixeln nicht modifizierte Regionen in Matrixform gebildet werden,
d) durch epitaxisches Wachstum wird in den Vertiefungen der Maske ein oberer Spiegel (8) aus p- oder n-dotiertem Halbleitermaterial auf zu dem unteren Spiegel umgekehrter Weise aufgebracht,
e) die in Kontakt mit der dielektrischen Schicht stehenden Ränder der oberen Spiegel werden derart metallisiert, daß eine Öffnung im Zentrum des Spiegels jedes Pixels für die optischen Ein-/Ausgänge des Pixels freigelassen wird.

2. Verfahren nach Anspruch 1, dadurch gekennzeichnet, daß die aktive Zone mit intrinsischen Quantentöpfen von dem Typ GaAs/GaAlAs oder GaAs/GaInAs oder InP/InGaAs/InGaAsP ist.

3. Verfahren nach Anspruch 1, dadurch gekennzeichnet, daß die dielektrische Maske auf der Basis von SiO ist.

4. Verfahren nach einem der Ansprüche 1 bis 3, dadurch gekennzeichnet, daß die oberen Spiegel zur Sicherstellung des ohmschen Kontakts durch Ionenimplantation überdotiert sind.

5. Verfahren nach Anspruch 1, dadurch gekennzeichnet, daß die Dicke der dielektrischen Maske mindestens gleich der Dicke des oberen Spiegels ist.

6. Verfahren nach Anspruch 1, dadurch gekennzeichnet, daß die Kontakte des oberen Spiegels als Einfassung um das Pixel und derart aufgebracht sind, daß die dielektrische Maske als Isolation zwischen den Pixeln verwendet wird.

7. Verfahren nach Anspruch 1, dadurch gekennzeichnet, daß vor der Metallisierung ein wesentlicher Teil der Dicke der dielektrischen Maske entfernt wird und die metallische Schicht auf den freiliegenden Rändern und Seitenflächen der oberen Spiegel aufgebracht wird, wobei die verbleibende dielektrische Schicht die elektrische Isolierung zwischen den Pixeln sicherstellt.

8. Verfahren nach Anspruch 1, dadurch gekennzeichnet, daß vor der Metallisierung die dielektrische Maske und ein Teil der diffundierten Schichten zwischen den Pixeln entfernt werden und die metallische Schicht auf den Rändern und den Seitenflächen der oberen Spiegel, auf den freiliegenden Seitenflächen der aktivierten pixelisierten Regionen aufgebracht wird, die verbleibenden nicht-pixelisierten diffundierten Regionen stellen die elektrische Isolierung zwischen den Pixeln sicher.

## Claims

1. A process for producing an electrically controllable matrix of virtually-structured quantum well components from a doped n or p substrate (1) on which has been deposited, by epitaxy, a doped n or p lower mirror (2) composed of one or several alternations of semiconductor thin layers surmounted by an active "epitaxiated" layer (3) made up of quantum well heterostructures, including the following steps:
a) the active quantum well layer is encapsulated with a dielectric layer (4) capable of inducing an alloy interdiffusion in the said quantum well layer,
b) the said dielectric layer (4) is etched in such a way as to create a self-alignment mask (5) demarcating recesses (6) with respect to the non-covered regions of the active layer,
c) the substrate covered by the self-alignment mask is treated thermally so as to create in the active layer, by alloy interdiffusion, vertically-divided regions (7) whose composition is modified in relation to the original state corresponding to interpixel regions, and also to create non-modified regions corresponding to pixels in matrix form,
d) an upper mirror (8) in doped p or n semiconductor material inversely to the lower mirror, is deposited by "epitaxial" growth in the recesses of the mask,
e) the edges of the upper mirrors in contact with the dielectric layer are metallized so as to leave an opening at the center of the mirror of each pixel for the optical inputs and outputs of the pixel.

2. A process according to claim 1, characterized in that the intrinsic quantum well active zone is of GaAs/GaAlAs or GaAs/GaInAs or InP/InGaAs/InGaAsP type.

3. A process according to claim 1, characterized in that the dielectric mask is SiO-based.

4. A process according to one of claims 1 to 3, characterized in that the upper mirrors are superdoped by ion implantation in order to ensure ohmic contact.

5. A process according to claim 1, characterized in that the thickness of the dielectric mask is at least equal to the thickness of the upper mirrors.

6. A process according to claim 1, characterized in that the contacts of the upper mirror are deposited in a ring around the pixel so as to use the dielectric mask as interpixel insulator.

7. A process according to claim 1, characterized in that, before metallizing, a substantial part of the thickness of the dielectric mask is removed and the metallic layer is deposited on the uncovered edges and sides of the upper mirrors, the remaining dielectric layer ensuring interpixel electric insulation.

8. A process according to claim 1, characterized in that, before metallizing, the dielectric mask and a part of the interpixel interdiffused layers are removed and the metallic layer is deposited on the edges and sides of the upper mirrors, the remaining interdiffused non pixelised regions ensuring interpixel electric insulation.
